# EUROPEAN PATENT SPECIFICATION

(11) **EP 2 392 028 B1**
(45) Date of publication and mention of the grant of the patent: **22.08.2018**
(21) Application number: 10736231.1
(22) Date of filing: 19.01.2010
(51) Int. Cl.: H01L 23/522, H01L 27/04, H01L 49/02

(54) **INTEGRATED CIRCUIT WITH DOPED SUBSTRATE AND WITH AN INDUCTOR**
INTEGRIERTER SCHALTKREIS MIT EINEM DOTIERTEN SUBSTRAT UND MIT EINEM INDUKTOR
CIRCUIT INTÉGRÉ DOTÉ D'UN SUBSTRAT DOPÉ ET COMPRENANT UNE BOBINE D'INDUCTION

(30) Priority: 30.01.2009 US 363545
(43) Date of publication of application: 07.12.2011
(73) Proprietor: Altera Corporation, San Jose, CA 95134 (US)
(72) Inventor: WATT, Jeffrey, T., Palo Alto CA 94306 (US); CHEN, Shuxian, Fremont CA 94539 (US)
(74) Representative: Appelt, Christian W.
(86) International application number: PCT/US2010/021397
(87) International publication number: WO 2010/088099

(56) References cited:
- EP-A1- 1 890 335
- WO-A2-00/70684
- JP-A- 2000 260 950
- JP-A- 2000 260 950
- JP-A- 2001 053 225
- US-A1- 2004 012 066
- US-A1- 2004 094 822
- US-A1- 2005 023 639
- US-B1- 6 225 677
- US-B1- 6 555 893

## Description

This application claims priority to United States patent application No. 12/363,545, filed January 30, 2009.

### Background

This invention relates to integrated circuit inductors, and more particularly, to integrated circuit inductors with doped substrate regions.

It is often necessary to provide inductors on integrated circuits. For example, inductors are often used for applications such as radio-frequency circuits, microwave circuits, and other analog circuit applications. Although it is sometimes possible to make use of external inductors, inductors that are formed on the integrated circuit itself are often preferred or required for reasons of performance, reliability, or cost efficiency.

When designing an inductor on an integrated circuit, it is important to minimize undesired coupling effects that may arise between the inductor and the integrated circuit substrate. These effects may include coupling capacitances between the inductor and substrate or electromagnetic fields that induce eddy currents in the substrate. Coupling capacitances and eddy currents may reduce the effectiveness of an inductor. The effectiveness of an inductor is typically characterized by a quality factor Q, which is proportional to the energy stored in an inductor divided by the energy dissipated in one oscillation cycle. Coupling effects between an inductor and substrate may reduce quality factor Q.

Typical techniques for reducing substrate coupling effects include placing the inductor on one of the uppermost layers of a dielectric stack on an integrated circuit to maximize the distance between the inductor and substrate. A layer of patterned conductive material may also be formed between the inductor and the substrate to shield the substrate from electromagnetic fields. These techniques are not always sufficient to produce desired Q factors.

It would therefore be desirable to be able to provide integrated circuit inductors that have reduced substrate coupling effects and satisfactory quality factors.

US 2004/094822 A1 relates to a low substrate loss inductor, which has a substrate, a plurality of p type doping areas and a plurality of n type doping areas formed alternatively inside the substrate, an insulating layer formed on the substrate, and a metal coil formed on the insulation layer. The insulation layer isolates the metal coil from the p type doping areas and n type doping areas. The doping areas are arranged orthogonal to the metal coil and serve as metallic shielding against eddy currents in the substrate. US 6,555,893 B1 provides a bar circuit for reducing cross talk and eddy current of an integrated circuit. The bar circuit comprises a semiconductor substrate with a first conductivity type; a strip of first well with a second conductivity type in the semiconductor substrate; and a strip of second well with the second conductivity type in the semiconductor substrate. The strip of second well is located below and adjacent to the strip of first well, whereby forms a junction barrier for reducing the cross talk and the eddy current.

JP 2000/260950 A relates to a coil for use in a integrated circuit. In order to improve high-frequency characteristics by suppressing an eddy current, even in an inductance element with small dimensions, the coil is formed on a P-type silicon substrate 1 by a second- layer wiring 11, and a polycrystalline silicon containing an N-type high-concentration impurity is embedded into a hole 5 provided in the P-type silicon substrate 1 at the lower portion of the coil for forming a P-N junction in an area to the P-type silicon substrate 1, and an reverse bias is applied to the P-N junction and hence spreading a depletion layer in the P-type silicon substrate 1 and forming an electrically insulated region.

US 2005/023639 A1 shows an inductor in an integrated circuit which comprises a conductive trace disposed over an insulating layer which overlies a semiconductor substrate of a first conductivity type and at least two deep wells of opposite conductivity type in the substrate underneath the track. In some implementations an inductor in an integrated circuit comprises a conductive trace disposed over an insulating layer which overlies a semiconductor substrate of a first conductivity type; a shallow trench isolation region formed in the substrate underneath the trace; and at least two deep wells of opposite conductivity type in the substrate underneath the shallow trench isolation region.

US 6,225,677 B1 discloses an integrated circuit in which a plurality of PN junctions are formed at the surface of a semiconductor substrate under a belt-like conductive film having a spiral shape which constitutes an inductance device. A reverse bias voltage is applied to the PN junctions, and the surface of the substrate is completely depleted. Since the reverse bias voltage is applied to the PN junctions, even though the impurity density of the surface of the substrate is high and the adjacent PN junctions are separated to a degree, the extension of the depletion layers can be increased and complete depletion of the surface of the substrate can be achieved.

### Summary

The invention is defined by independent claim 1. Advantageous embodiments are subject to the dependent claims.

In accordance with the present invention, an integrated circuit is provided that has an inductor and a substrate. The substrate is selectively doped and biased in order to minimize undesired coupling effects between the inductor and substrate.

The substrate is a p-type substrate. Portions of the substrate have n-type doped regions. Generally, the n-type doped regions may include n-type wells ("n-wells"), deep n-type wells ("deep n-wells"), and n+ regions. Combinations of n-type doped regions may also be used. According to the invention, n+ regions are formed in n-type wells, and the n-type wells may be optionally formed above deep n-type wells.

The n-type doped regions are formed on the substrate in a pattern of strips of n-type doped regions.
The strips may be separated from each other by a spacing of undoped substrate. The strips may be formed orthogonal to the spiral conductive lines of the inductor to minimize possible eddy currents that may be induced in the substrate and n-doped regions due to the proximity of the inductor. The strips may, for example, be L-shaped strips.

The n-type doped regions are positively biased relative to the p-type substrate. The positive bias causes a depleted region (depletion region) to form between the strips of n-type doped regions. The depleted region may extend for a certain depth into the substrate. The depleted region may extend deeper into the substrate than the n-type doped regions. The depleted region may increase the effective distance between the inductor and substrate, minimizing undesired coupling effects between inductor and substrate.

Further features of the invention, its nature, and various advantages will be more apparent from the accompanying drawings and the following detailed description.

### Brief Description of the Drawings

FIG. 1 is a cross sectional view of an integrated circuit showing metal layers and via layers in a dielectric stack in accordance with an embodiment of the present invention.
FIG. 2 is a top view of a spiral inductor in accordance with an embodiment of the present invention.
FIG. 3 is a top view of a patterned ground shield that may be used in accordance with an embodiment of the present invention.
FIG. 4 is a cross sectional view of an integrated circuit with an inductor and a substrate that has doped regions.
FIG. 5 is a cross sectional view of an integrated circuit with an inductor and a substrate with biased n-wells and a depleted region in accordance with an embodiment of the present invention.
FIG. 6 is a cross sectional view of an integrated circuit with an inductor and a substrate with n+ regions, n-wells, and a depleted region in accordance with an embodiment of the present invention.
FIG. 7 is a cross sectional view of an integrated circuit showing a substrate with n+ regions, n-wells, and deep n-wells in accordance with an embodiment of the present invention.
FIG. 8 is a cross sectional view of an integrated circuit showing a substrate with n+ regions.
FIG. 9 is a top view of a substrate with n-type doped regions and a depleted region.
FIG. 10 is a top view of a substrate with strip-shaped n-wells that contain strip-shaped n+ regions in accordance with an embodiment of the present invention.
FIG. 11 is a top view of a substrate containing an illustrative comb-shaped pattern of n-wells in accordance with an embodiment of the present invention.
FIG. 12 is a cross sectional view of a portion of a substrate showing how doped substrate regions may be silicided to enhance conductivity in accordance with an embodiment of the present invention.

### Detailed Description

The present invention relates to integrated circuit inductors with doped substrate regions for minimizing inductor-to-substrate coupling.

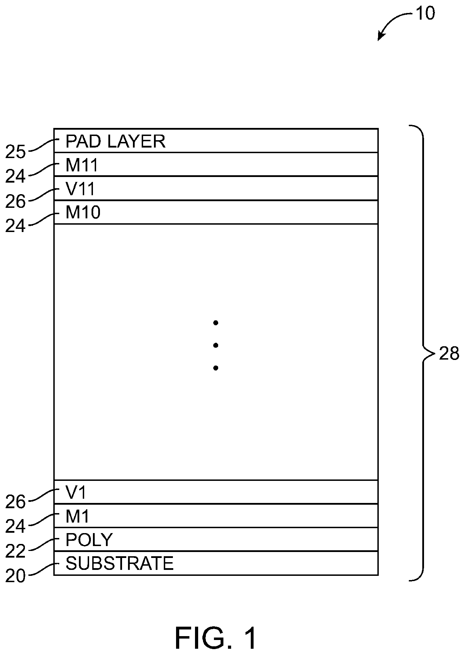

A cross section of an integrated circuit is shown in FIG. 1. Integrated circuit 10 in FIG. 1 has a silicon substrate 20. Substrate 20 is a p-type substrate. Above substrate 20 is a polysilicon layer 22 that may be used to form conductive regions for devices located in substrate 20. Above polysilicon layer 22 are alternating metal layers 24 and via layers 26. Metal layers 24 may be used to form conductive paths between devices on integrated circuit 10. The spaces between conductive paths in metal layer 24 are typically filled with dielectric material. Via layers 26 may contain short vertical conductive "vias" that form connections between metal layers 24. Dielectric material may fill the spaces between vias on via layers 26. Metal layers 24 are typically numbered "M1, M2..." beginning with the metal layer 24 closest to substrate 20. Via layers 26 are typically numbered "V1, V2..." beginning with the via layer 26 closest to substrate 20. Collectively, metal layers 24 and via layers 26 may be known as dielectric stack 28. FIG. 1 shows eleven metal layers 24 and ten via layers 26, but there may be any number of metal layers 24 and via layers 26 on dielectric stack 28. For example, there may be six metal layers 24 or eight metal layers 24. Above dielectric stack 28 may be a pad layer 25. Pad layer 25 may be an aluminum copper layer or other conductive layer used for forming contact pads.

In order to minimize undesired substrate coupling effects, an integrated circuit inductor is often formed in one of the highest layers of a dielectric stack 28 of an integrated circuit 10. This maximizes the distance between the inductor and substrate 20. For example, in an integrated circuit such as integrated circuit 10 of FIG. 1 that contains eleven metal layers 24, an inductor may be formed in metal layer M11. If an integrated circuit contains a different number of metal layers, an inductor may be formed in the uppermost metal layer 24. An inductor may also be formed in portions of two different metal layers 24, such as the uppermost two metal layers 24 (e.g., metal layers M10 and M11 connected by vias in vias layer V10 in FIG. 1). An inductor may also be formed in portions of an uppermost metal layer 24 and a pad layer 25.

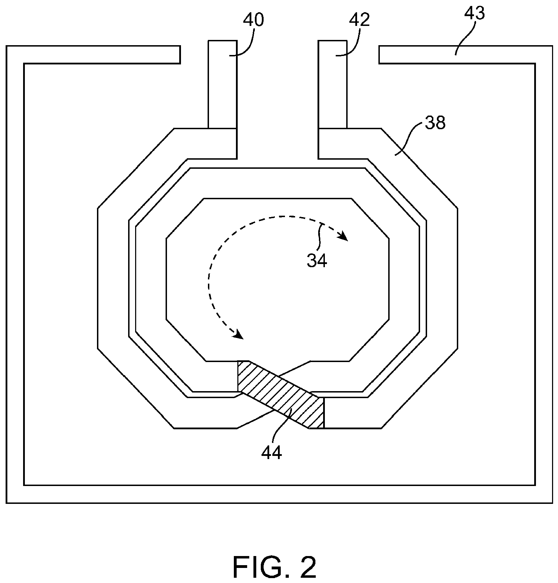

A spiral inductor 38 of the type that may be used in an integrated circuit 10 is shown in FIG. 2. Spiral inductor 38 may be formed in one or more of the uppermost layers of dielectric stack 28, such as metal layer M11 (see, e.g., FIG. 1). Spiral inductor 38 has terminals 40 and 42 through which a signal may be supplied to inductor 38 from circuitry on device 10. Inductor 38 may have an overlapping segment 44 that is formed in a layer above or below the metal layer that contains the other portions of the inductor. For example, if the main portions of inductor 38 are formed in an uppermost metal layer 24 such as metal layer M11 of FIG. 1, the overlap segment 44 may be formed in pad layer 25 of FIG. 1. Overlap segment 44 may also be formed in a metal layer such as metal layer M10 of FIG. 1. When magnetic flux from inductor 38 induces eddy currents in portions of integrated circuit 10 such as substrate 20 of FIG. 1, the eddy currents will tend to be oriented in the direction shown by arrow 34 (i.e. parallel to the spiral of inductor 38) .

In FIG. 2, inductor 38 is shown as being formed of straight segments that are linked to together to form an eight-sided geometry. However, any suitable geometry may be used for inductor 38. If desired, inductor 38 may have a circular geometry, a square geometry, or any other suitable geometry. Inductor 38 may be formed from lines of any suitable line width. Spiral inductor 38 is shown having two concentric spirals, but inductor 38 may have any suitable number of spirals. Spiral inductor 38 may be of any suitable size. Spiral inductor 38 may, for example, also have a diameter of 100 microns, 200 microns, 500 microns, or other suitable diameters. Spiral inductor 38 may operate at any suitable frequency. For example, spiral inductor may operate at 1 GHz, 2 GHz, 6 GHz, etc. Spiral inductor 38 may be designed to maximize performance for a desired frequency range.

The line width of the lines that form inductor 38 contributes to a series resistance for inductor 38. Wider lines lead to a lower series resistance which tends to increase the quality factor Q for inductor 38. To decrease series resistance, inductor 38 may be formed in two adjacent metal layers 24, so that portions of the inductor in one metal layer 24 lie directly over portions of the inductor in another metal layer 24. (As in example, the inductor could be formed in metal layer M10 and metal layer M11 of FIG. 1). The portions of the inductor in the two metal layers may be connected by vertical vias in the intervening via layer 26 (such as via layer V10 in the example). Forming such an inductor with repeated lines in two metal layers 24 may decrease the series resistance of the inductor by increasing the effective width of lines in the inductor.

A guard ring such as guard ring 43 may be formed around the perimeter of inductor 38. Guard ring 43 may be formed in any suitable metal layer 24 of FIG. 1. Guard ring 43 may be formed in the same metal layer 24 of inductor 28, or guard ring 43 may be formed in a different metal layer, such as metal layer M1 of FIG. 1. Guard ring 42 may be formed of a conductive material and may serve to shield other components on integrated circuit 10 from stray electromagnetic fields from inductor 38. In the example of FIG. 2, guard ring 43 has a square geometry with an open side. It may be desirable for guard ring 43 to have an open side so that it is not completely connected around the perimeter of inductor 38. As inductor 38 tends to induce eddy currents parallel to the spiral of inductor 38, as indicated by arrow 34, a guard ring 43 that has an open side may be less prone to induced eddy currents than a guard ring that is connected around the perimeter of inductor 38. Guard ring 43 may have any suitable geometry and need not have the four-sided geometry as shown in FIG. 2. Guard ring 54 may be eight-sided or may have other suitable shapes.

Maximizing the distance between inductor 38 and substrate 20 by forming inductor 38 in uppermost metal layers 24 may reduce undesired substrate coupling effects. Other strategies may be used to further reduce undesired substrate coupling effects and thereby increase quality factor Q of inductor 38.

The formation of induced eddy currents in substrate 20 can be reduced by placing a conductive shield between inductor 38 and substrate 20. Such a conductive shield can help shield substrate 20 from magnetic fields from inductor 38 and thereby reduce the formation of eddy currents in substrate 20. In order to reduce the formation of eddy currents in the conductive shield itself, the conductive shield may be patterned so that no complete circuit exists in the direction of potential eddy currents (i.e. in the direction parallel to the spiral of inductor 38 as indicated by arrow 34 of FIG. 2) just as the open side of guard ring 43 can serve to reduce the formation of eddy currents in guard ring 43 in FIG. 2.

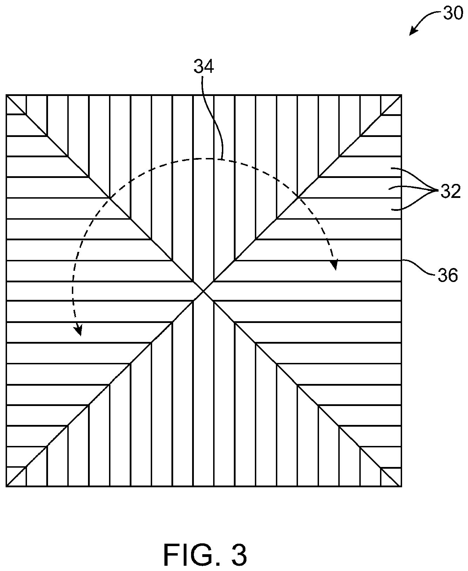

An illustrative patterned ground shield 30 is shown in FIG. 3. Ground shield 30 can be used to shield substrate 20 from magnetic fields from inductor 38. Patterned ground shield 30 may be formed from strips of conductive material that are arranged perpendicular to the direction of potential eddy currents. Arrow 34 in FIG. 3 indicates the direction of potential eddy currents. Conductive strips 32 are arranged perpendicular to eddy current path 34, so that potential eddy currents are stopped by the slots 36 between conductive strips 32. Patterned ground shield 30 can be made of conductive materials formed in a metal layer 24 of dielectric stack 28 or in a polysilicon layer 22 (see, e.g., FIG. 1). If patterned ground shield 30 is formed in a metal layer 24, patterned ground shield 30 can be formed in the lowermost metal layer M1 in order to minimize the formation of eddy currents in patterned ground shield 30.

A patterned ground shield such as a patterned ground shield 30 in FIG. 3 can increase the quality factor Q for an inductor 38 by shielding substrate 20 from magnetic fields from inductor 38. However, a patterned ground shield is closer to inductor 38 than substrate 20. The proximity of patterned ground shield 30 to inductor 38 can potentially allow an undesirable capacitive coupling to arise between inductor 38 and substrate 20. Slots 36 serve to reduce the strength of eddy currents, but slots 36 may also allow magnetic flux to pass through patterned ground shield 30 and reach substrate 20. In some circumstances, the presence of a patterned ground shield may therefore not increase quality factor Q of inductor 38.

As a result of the various ways in which the presence of patterned ground shield 30 can affect the performance of inductor 30, pattern ground shield 30 can be advantageous when inductor 38 is functioning in some frequencies but be disadvantageous when inductor 38 is functioning in other frequencies. For example, for a given integrated circuit 10 that has an inductor 38, a patterned ground shield 30 may increase quality factor Q for frequencies of 1-2 GHz but may decrease quality factor Q for frequencies such as 4 GHz or 6 GHz. For such an example, it would not be advantageous to have a patterned ground shield 30 if inductor 30 were required to operate at frequencies of 4 GHz or 6 GHz. It would be desirable to have a way of minimizing undesirable coupling effects between inductor 38 and substrate 20 at frequencies at which patterned ground shield 30 may be ineffective.

It may be desirable to further increase the distance between inductor 38 and substrate 20 in order to decrease such undesirable effects such as capacitive coupling between inductor 38 and substrate 20 and formation of eddy currents in substrate 20. The effective distance between inductor 38 and substrate 20 may be increased by forming a depleted region on the surface of substrate 20. Such a depleted region may be free of carriers and therefore not susceptible to capacitive coupling or induced eddy currents. Such a depleted region may be created by forming doped regions in a substrate and reverse biasing the doped regions.

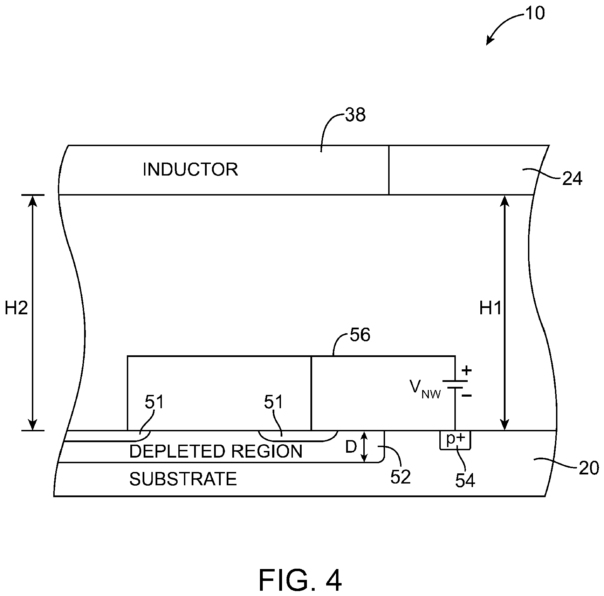

FIG. 4 shows a cross section of integrated circuit 10. There may be a height H1 that characterizes the distance between inductor 38 in metal layer(s) 24 and substrate 20. If substrate 20 is a p-type substrate, n-type doped regions 51 may be formed in substrate 20. Bias voltage V_{NW} may be conveyed to n-type doped regions 51 along a path such as bias voltage path 56. Bias voltage V_{NW} may be supplied between bias voltage path 56 and a p+ region 54 that is used to make electrical (Ohmic) contact with substrate 20. If a reverse bias V_{NW} voltage is applied between the n-type doped regions 51 and p-type substrate 20, such that the n-type doped regions 51 are held at a positive voltage relative to substrate 20, then depleted regions 52 (sometimes referred to as a depletion region or regions) may form at the junctions between the n-type doped regions 51 and substrate 20. If n-type doped regions 51 have a higher carrier concentration than substrate 20, then depleted regions 52 may extend further into substrate 20 than into n-type doped regions 51. The width of depletion regions 52 may be increased by using a bias voltage V_{NW} of a larger magnitude. Depleted region 52 may have a width that is dependent on the magnitude of V_{NW}. For example, a bias voltage V_{NW} of 5 V may correspond to a depletion width of 2.4 microns, while a bias voltage V_{NW} of 2 V may correspond to a depletion width of 1.5 microns. These values of bias voltage V_{NW} and depletion width are merely illustrative. If a high enough bias voltage is applied, the depleted region 52 may form a layer as shown by depleted region 52 in FIG. 3. Depleted region 52 may extend a depth D into substrate 20.

Depleted regions 52 may be free of carriers and therefore not susceptible to capacitive coupling with inductor 38 or to the formation of eddy currents. As a result, depleted layer 52 may increase the effective distance between inductor 38 and substrate 20 from height H1 to height H2, where height H2 is greater than height H1 by the depth D that depleted region 52 extends into substrate 20. Typical values for height H1 may be 8 microns or 9 microns. Typical values for height H2 may be 10 microns or 11 microns. Height H2 and height H2 may have any suitable values.

If desired, substrate 20 may be an n-type substrate. If substrate 20 is an n-type substrate, then p-type doped regions may be formed in n-type substrate 20, and a bias voltage may be applied between p-type doped regions and n-type substrate 20 such that n-type substrate 20 is held at a positive voltage relative to p-type doped regions. Depleted regions may form at the junctions between p-type doped regions and n-type substrate 20.

Increasing the effective distance between inductor 38 and substrate 20 by forming depleted regions 52 may increase quality factor Q for inductor 38. Depleted regions 52 may increase quality factor Q for frequencies ranges for which a patterned ground shield might not be effective. Depleted regions 52 may also increase quality factor Q for those frequencies ranges in which patterned ground shield increases quality factor Q. Depleted regions 52 may be advantageous for quality factor Q of inductor 38 for frequencies in the range of 2 GHz, 6 GHz, 20 GHz, etc.

If substrate 20 is a p-type substrate, various types of n-type doped regions may be used to form n-type doped regions 51 of FIG. 4. N-type doped regions 51 may, for example, be implanted or diffused into substrate 20. To simplify processing steps, it may be advantageous to use n-type doped regions that are of the type that are simultaneously being used to make devices in other part of integrated circuit 10. For example, n-type wells ("n-wells") may be used for n-type doped regions 51. In other parts of integrated circuit 10, devices such as p-channel metal-insulator-semiconductor (PMOS) transistors may be formed in n-wells of the same type. N-wells may typically have a carrier concentration on the order of 10¹⁸ cm⁻³. Deep n-type wells ("deep n-wells") may also be used for n-type doped regions 51 of FIG. 4. Deep n-wells may be used in other parts of integrated circuit 10 to isolate certain devices. N+ regions may also be used as n-type doped regions 51 of FIG. 4. In other parts of integrated circuit 10, the n+ regions may serve as n+ source and drain regions for devices such as n-channel metal-insulator-semiconductor (NMOS) transistor. N+ regions may have a carrier concentration on the order of 10¹⁹ cm⁻³. A combination of n-wells, deep n-wells, and n+ regions may also be used for n-type doped regions 51.

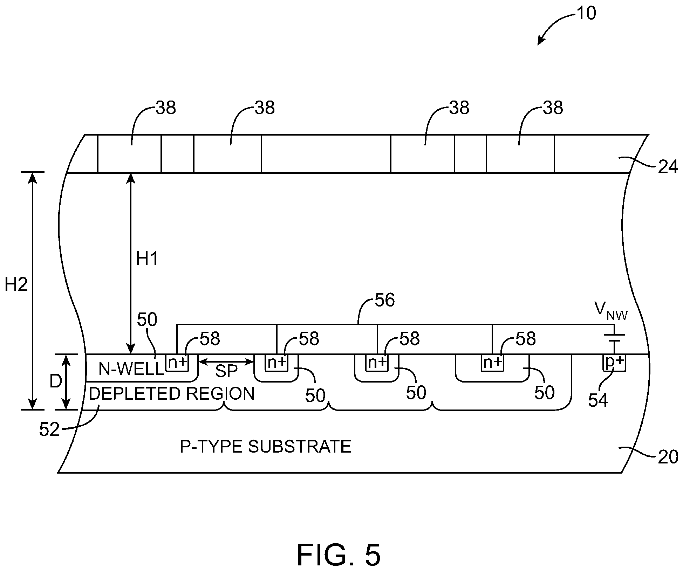

FIG. 5 shows a cross-section of integrated circuit 10 with n-wells 50 used as n-type regions 51 of FIG. 4. Cross-sections of inductor 38 are shown in metal layer 24. Substrate 20 in FIG. 5 is a p-type substrate. N-wells 50 are formed in substrate 20 separated by a spacing sp. N-wells 50 are biased by a positive bias voltage V_{NW} relative to substrate 20. Bias voltage V_{NW} may be supplied to n-wells 50 on a path such as bias voltage supply path 56. Bias voltage V_{NW} may be connected to n+ contact regions 58 that may be used to establish better electrical contact with n-wells 50. Bias voltage V_{NW} may be supplied between path 56 and a p+ region 54 that is formed in substrate 20. Bias voltage V_{NW} may have any suitable magnitude. Bias voltage V_{NW} may be, for example, 1 V, 5 V, 10 V, or other suitable voltages. Bias voltage V_{NW} causes a depleted region 52 to form at the junctions between n-well 50 and substrate 20. As the magnitude of bias voltage V_{NW} increases, the size of depleted region 52 increases. Depleted regions 52 that are located close to n-wells 50 at relatively low bias levels may become larger and eventually merge together and form a layer such as shown by depleted region 52 in FIG. 4 at higher biases. Depleted region 52 may, if desired, fill the spacing sp between n-wells 50 on the surface of substrate 20. Depleted region 52 may have a depth D that extends deeper into substrate 20 than n-wells 50.

As depleted region 52 does not have charge carriers, depleted region 52 is not susceptible to the formation of eddy currents. The presence of depleted region 52 effectively increases the height between inductor 38 and substrate 20 from height H1 to height H2. Height H2 is the sum of height H1 and the depth D that depleted region 52 may extend into substrate 20. The increase in the effective height of inductor 38 above substrate 20 may decrease the amount of undesired coupling between inductor 38 and substrate 20 and thereby increase quality factor Q for inductor 38.

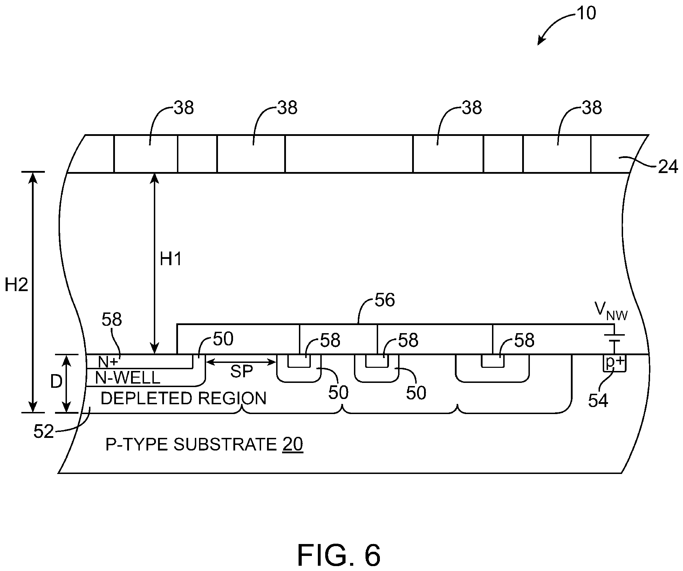

FIG. 6 shows a cross section of an integrated circuit 10 with both n+ regions 58 and n-wells 50 used to form n-type regions 51 of FIG. 4. Cross sections of spiral inductor 38 are shown in metal layer 24. Substrate 20 is a p-type substrate. N-wells 50 are formed in substrate 20. N-wells 50 may be separated by a spacing sp. N+ regions 58 are formed in n-wells 50. N+ regions 58 are silicided for improved conductivity. Bias voltage V_{NW} may be distributed to n+ regions 58 along a path such as bias voltage supply path 56. Bias voltage V_{NW} may be supplied between bias voltage supply path 56 and a p+ region 54 that may be connected to substrate 20. Bias voltage V_{NW} causes a depleted region 52 to form in the junctions of n-wells 50 and substrate 20. Any suitable bias voltage V_{NW} may be used. As voltage V_{NW} increases, depleted region 52 may form a layer such as that shown in FIG. 6. Depleted region 52 may fill the spacing sp between n-wells 50. Depleted region 52 may extend a depth D below the surface of substrate 20 that is greater than the depth of n-wells 50 in substrate 20. As with depleted region 52 in FIG. 5, depleted region 52 of FIG. 6 may increase the effective height between inductor 38 and substrate 20 from height H1 to height H2. As N+ regions 58 have a greater carrier concentration than N-wells 50, the presence of N+ regions 58 serve also serve as metallic shielding, keeping magnetic flux from reaching substrate 20 from electromagnetic fields.

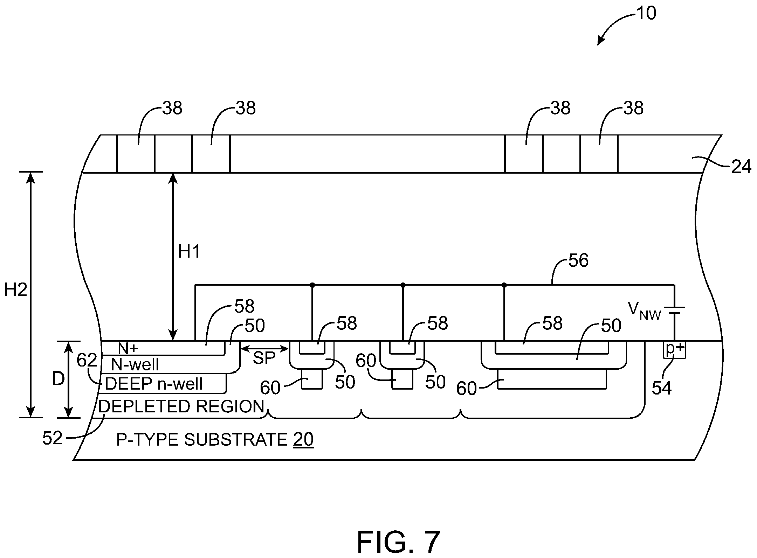

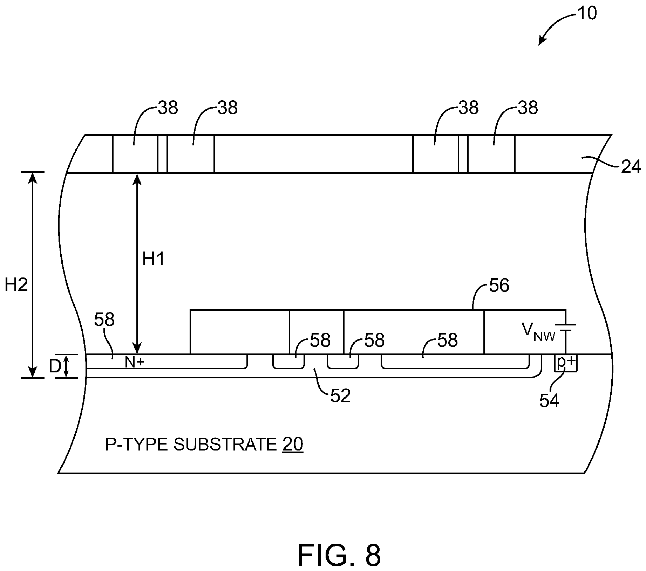

FIG. 7 shows a cross section of integrated circuit 10 in which a combination deep n-wells 62, n-wells 50, and n+ regions 58 have been used for n-type doped regions 51 of FIG. 4. Cross sections of inductor 38 are shown in metal layer 24. Substrate 20 is a p-type substrate. Deep n-wells 62 may be formed in substrate 20. N-wells 50 are formed in the substrate, above deep n-wells 62 and n+ regions 58 are formed above n-wells 50. Deep n-wells 62, n-wells 50, and n+ regions 58 are biased by a positive bias voltage V_{NW} relative to substrate 20. N+ regions 58 may be connected by a conductive path such as bias voltage path 56. A bias voltage V_{NW} may be applied between bias voltage path 56 and p+ region 54 in substrate 20. Bias voltage V_{NW} may cause depleted region 52 to form between n-type doped regions and p-type substrate. Depleted region 52 may fill the spacing sp and may extend a depth D below the surface of substrate 20. Depth D may extend below deep n-well 62. Deep n-wells 62 may allow depth D of depleted region 52 to be greater than depth D when n-wells 52 are used alone, such as in FIG. 6. The formation of depleted region 52 in substrate 20 may increase the effective height of inductor 38 above substrate 20 from height H1 to height H2, where height H2 is height H1 + depth D. In an example not forming part of the invention, N+ regions 58 may also be used without accompanying n-wells 50 and deep n-wells 62, as shown in FIG. 8. N+ regions 58 may be silicided for improved conductivity. Cross-sections of spiral inductors 38 are shown in metal layer 24. Integrated circuit 10 in FIG. 8 may have p-type substrate 20. N+ regions 58 may be formed in substrate 20. If desired, a bias voltage V_{NW} may be applied between n+ regions 58 and substrate 20 such that n+ regions 58 are held at a positive bias voltage V_{NW} relative to substrate 20. Bias voltage V_{NW} may produce a depleted region 52 that may extend for a depth D below the surface of substrate 20. Depleted region 52 may have the effect of increasing the effective height between inductor 38 and substrate 20 from height H1 to height H2, where height H2 is height H1 + depth D. If desired, n+ regions 58 may be grounded (i.e. V_{NW} set to zero). If n+ regions 58 are grounded, n+ regions 58 may primarily serve as metallic shielding.

Other non inventive combinations of n-type doped regions may be used for n-type doped regions 51 of FIG. 4. For example, deep n-wells 62 may be used with n-wells 50, but without n+ regions 58. Deep n-wells 62 may also be used with n+ regions 58, but without n-wells 50. Deep n-wells 62 may also be used alone. Combinations of n-type doped regions that have n+ regions 58 may be advantageous in that the more conductive n+ regions 58 serve as metallic shielding. Smaller n+ regions 58 such as n+ regions 58 in FIG. 5 may be used to establish better electrical contact with n-wells 50 and deep n-wells 62.

When using n-type doped regions 51 to form depleted regions 52 in substrate 20, it would be desirable to have n-type doped regions 51 and depleted regions 52 extend across most or all of the portion of substrate 20 that is directly below inductor 38. Any suitable technique may be used to pattern n-type doped regions 51 across this portion of substrate 20. As n-type doped regions 51 have charge carriers, it may be desirable to have n-type doped regions 51 patterned in such a way as to interrupt the flow of induced eddy currents that may form in n-type doped regions 51. With one suitable arrangement, n-type doped regions 51 may be formed in strips that are perpendicular to the spiral of inductor 38.

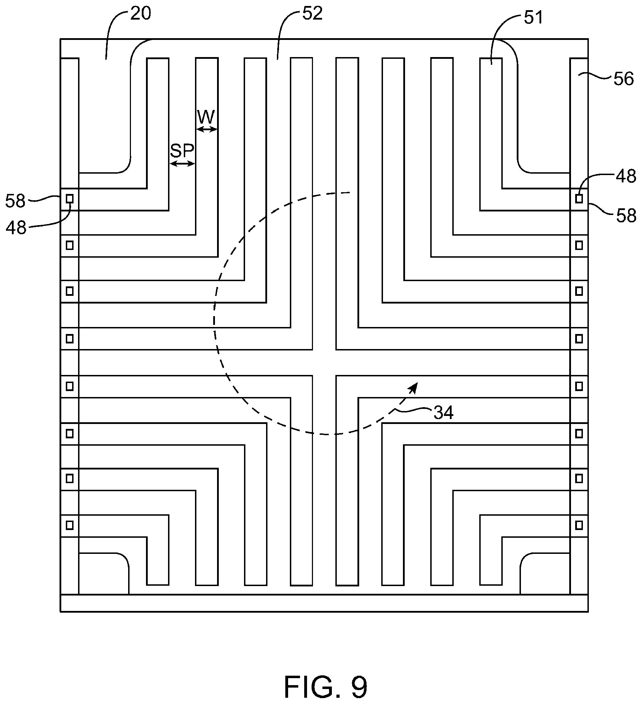

A pattern that may be used for n-type doped regions 51 in p-type substrate 20 is shown in FIG. 9. N-typed doped regions 51 in substrate 20 may be deep n-wells, n-wells, n+ regions, or any combination of deep n-wells, n-wells, and n+ regions. N-type doped regions 51 may be formed in L-shaped strips. L-shaped strips 51 may have a width w and have spacing sp. L-shaped strips 51 may be oriented perpendicular to the spiral of spiral inductor 38 of FIG. 3, and perpendicular to the direction of possible eddy currents 34. When n-type doped regions 51 are reverse biased (positively biased) relative to p-type substrate 20, depleted region 52 may form that fills the space between the n-type doped regions 51. Bias voltage V_{NW} may be supplied on a path such as bias voltage path 56, which in FIG. 9 is formed around the perimeter of n-type doped regions 51. Bias voltage supply path 56 may be formed in any suitable layer. Bias voltage supply path 56 may, for example, be formed in metal layer M1 of FIG. 1. Bias voltage path 56 is not completely closed around the perimeter in the arrangement of FIG. 9 to deter the formation of induced eddy currents in bias voltage path 62. N-type doped regions 51 may be attached to bias voltage path 56 by vias 48. If n-type doped regions 51 are n-wells 50 or deep n-wells 62 (or a combination of n-wells 50 and deep n-wells 62), then n+ contact regions 58 may be used to provide electrical contact between vias 48 and n-type doped regions 51. N+ contact regions 58 may be silicided for improved conductivity.

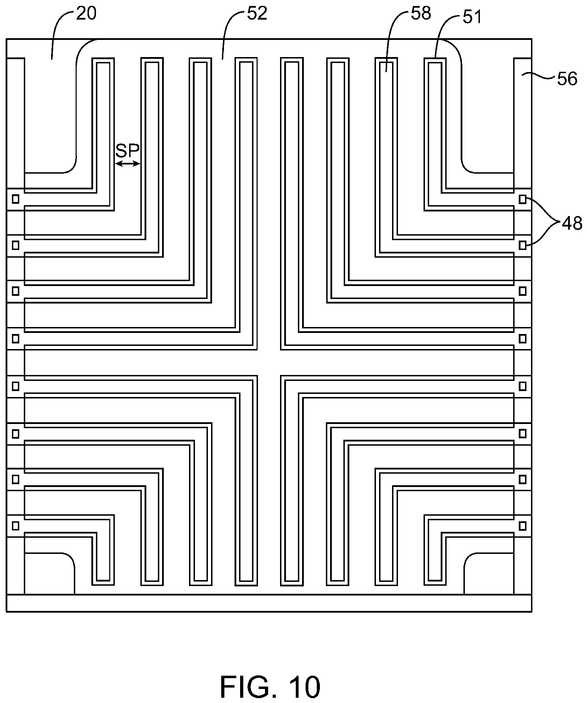

FIG. 10 shows a pattern that may be used when n+ regions 58 are formed in other n-type regions 51 such as n-wells 50 and deep n-wells 62. In FIG. 10, n-type regions 51 are shown as L-shaped strips 51. N-type regions 51 in FIG. 10 are n-wells 50 and may further include deep n-wells 62. N+ regions 58 are formed in slightly thinner L-shaped strips 58 that lie within the L-shaped strips of n-type regions 51. N+ regions 58 are silicided for improved conductivity. When n+ regions 58 and n-type regions 51 are biased, depleted region 52 forms in substrate 20, filling the spacing sp between the L-shaped strips. Bias voltage VNW may be supplied by a path such as bias voltage supply path 56. Bias voltage supply path 56 may be formed in any suitable metal layer, such as metal layer M1 of FIG. 1. N+ regions 58 may be attached to bias voltage supply path 56 by vias 48. Bias voltage supply path 56 may be formed in a metal layer such as metal layer M1. N+ regions 58 in FIG. 10 serve as metallic shielding, shielding substrate 20 from possible eddy currents.

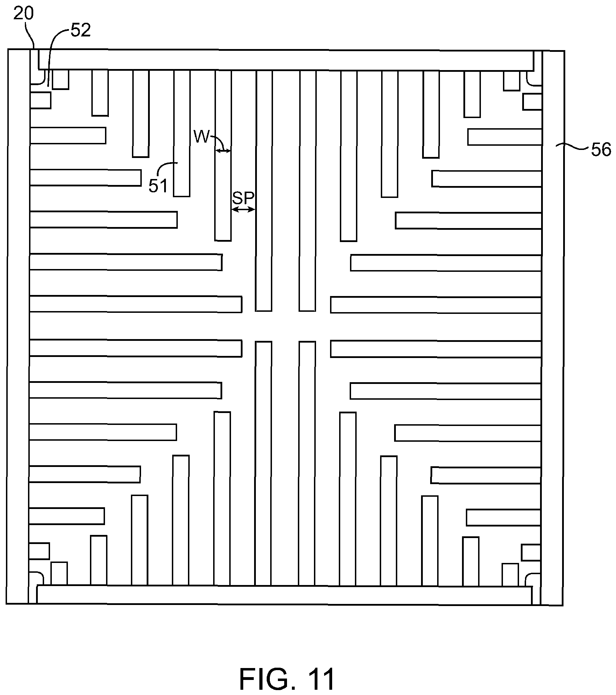

If desired, a pattern such as the triangular comb pattern of FIG. 11 may be used for n-typed doped regions 51. FIG. 11 shows a top view of p-type substrate 20. N-type doped regions 51 in FIG. 11 are a combination of n-wells 50 and n+ regions 58 and may further include deep n-wells 62. N-type doped regions 51 are formed as strips in substrate 20. The strips of n-type doped regions 51 may have a width w and a spacing sp. Strips 51 are oriented so that they are perpendicular to the spiral of inductor 38 (see, e.g., FIG. 2) and perpendicular to the direction of possible eddy currents. When n-type doped regions 51 are reverse biased (i.e., positively biased) relative to substrate 20, a depleted region 52 may 'form' that fills the space between the strips of n-type doped regions 51. Bias voltage V_{NW} may be supplied by bias voltage supply path 56. Bias voltage supply path 56 may be formed in any suitable layer of integrated circuit 10 (see, e.g., FIG. 1).

If desired, other suitable patterns may be used for n-typed doped regions 51. In non inventive examples, doped regions 51 need not be formed of strips. N-type doped regions 51 need not be arranged in a square geometry but may have any suitable geometry.

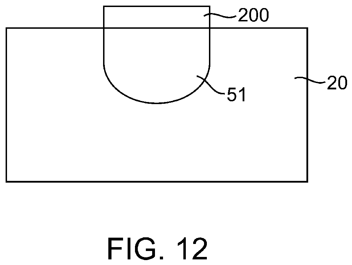

FIG. 12 shows a cross sectional view of an illustrative substrate 20 in which doped region 51 has been provided with a silicide layer 200. Doped region 51 is an n+ region within an n-well (e.g., n+ strips that are being used to enhance conductivity for metallic shielding as described in connection with strips 58 of FIG. 10). Silicide 200 may be formed by combining nickel or other suitable materials with silicon (e.g., part of substrate 20, part of a polysilicon layer, etc.). Silicide 200 may improve conductivity of underlying doped region 51 thereby enhancing quality factor Q. The foregoing is merely illustrative of the principles of the present invention and various modifications can be made by those skilled in the art without departing from the scope of the invention as defined by the appended claims.

## Claims

1. An integrated circuit, comprising:
a spiral inductor (38); and
a p-type substrate (20) that has a pattern of strips of n-type doped wells (50) below the spiral inductor (38),
wherein each of the strips of n-type doped wells (50) comprises a n+ doped strip (58) and a silicide layer (200) formed on said n+ doped strip (58),
wherein the n+ doped strips (58) extend in said strips of n-type doped wells (50), are adapted to be positively biased with respect to the substrate (20) such that the p-type substrate (20) is depleted between the n-type doped wells (50) and are adapted to serve as a metallic shielding against eddy currents in the substrate (20).

2. The integrated circuit defined in claim 1, wherein the substrate (20) further comprises deep n-type wells (62) formed below the n-type doped wells (50).

3. The integrated circuit defined in claim 1, wherein the strips of n-type doped wells (50) are formed in an L-shape on the p-type substrate (20); and wherein the n+ doped strips (58) are formed by respective L-shaped strips that lie within the L-shaped strips of the n-type doped wells (50).

4. The integrated circuit defined in claim 1 or 2, wherein the strips of n-type doped wells (50) and n+ doped strips (58) form strips of n-type doped regions (51) which are arranged in a triangular comb-shaped pattern on the p-type substrate (20) and wherein the strips are perpendicular to the spiral of the inductor (38).

## Patentansprüche

1. integrierter Schaltkreis, der Folgendes umfasst:
eine Spiralinduktivität (38); und
ein p-Typ-Substrat (20), das eine Struktur aus Streifen aus dotierten n-Typ-Wannen (50) unterhalb der Spiralinduktivität (38) aufweist,
wobei jeder der Streifen der dotierten n-Typ-Wannen (50) einen n⁺-dotierten Streifen (58) und eine Silicidschicht (200), die auf dem n⁺-dotierten Streifen (58) gebildet ist, umfasst,
wobei sich die n⁺-dotierten Streifen (58) in die Streifen aus dotierten n-Typ-Wannen (50) erstrecken, dazu eingerichtet sind, mit Bezug auf das Substrat (20) positiv vorgespannt zu werden, sodass das p-Typ-Substrat (20) zwischen den dotierten n-Typ-Wannen (50) verarmt ist, und dazu eingerichtet sind, als eine metallische Abschirmung vor Wirbelströmen in dem Substrat (20) zu dienen.

2. Integrierter Schaltkreis nach Anspruch 1, wobei das Substrat (20) ferner tiefe n-Typ-Wannen (62) umfasst, die unterhalb der dotierten n-Typ-Wannen (50) gebildet sind.

3. Integrierter Schaltkreis nach Anspruch 1, wobei die Streifen aus dotierten n-Typ-Wannen (50) in einer L-Form auf dem p-Typ-Substrat (20) gebildet sind; und wobei die n⁺-dotierten Streifen (58) durch jeweilige L-förmige Streifen gebildet sind, die innerhalb der L-förmigen Streifen der dotierten n-Typ-Wannen (50) liegen.

4. Integrierter Schaltkreis nach Anspruch 1 oder 2, wobei die Streifen aus dotierten n-Typ-Wannen (50) und n⁺-dotierten Streifen (58) Streifen aus dotierten n-Typ-Gebieten (51) bilden, die in einer dreieckigen kammförmigen Struktur auf dem p-Typ-Substrat (20) angeordnet sind, und wobei die Streifen senkrecht zu der Spirale der Induktivität (38) sind.

## Revendications

1. Circuit intégré, comprenant :
une bobine d'induction en spirale (38) ; et
un substrat de type p (20) qui a un motif de bandes de puits dopés de type n (50) au-dessous de la bobine d'induction en spirale (38),
dans lequel chacune des bandes de puits dopés de type n (50) comprend une bande dopée n+ (58) et une couche de siliciure (200) formée sur ladite bande dopée n+ (58),
dans lequel les bandes dopées n+ (58) s'étendent dans lesdites bandes de puits dopés de type n (50), sont adaptées pour être polarisées positivement par rapport au substrat (20) de telle sorte que le substrat de type p (20) est appauvri entre les puits dopés de type n (50) et sont adaptées pour servir de blindage métallique contre les courants de Foucault dans le substrat (20).

2. Circuit intégré défini dans la revendication 1, dans lequel le substrat (20) comprend en outre des puits profonds de type n (62) formés au-dessous des puits dopés de type n (50).

3. Circuit intégré défini dans la revendication 1, dans lequel les bandes de puits dopés de type n (50) sont façonnées en forme de L sur le substrat de type p (20) ; et dans lequel les bandes dopées n+ (58) sont formées par des bandes en forme de L respectives qui se situent à l'intérieur des bandes en forme de L des puits dopés de type n (50).

4. Circuit intégré défini dans la revendication 1 ou 2, dans lequel les bandes de puits dopés de type n (50) et les bandes dopées n+ (58) forment des bandes de régions dopées de type n (51) qui sont agencées en un motif en forme de peigne triangulaire sur le substrat de type p (20) et dans lequel les bandes sont perpendiculaires à la spirale de la bobine d'induction (38) .
